# EUROPEAN PATENT APPLICATION

(11) **EP 1 484 787 A1**
(43) Date of publication of application: **08.12.2004**
(21) Application number: 03744004.7
(22) Date of filing: 06.03.2003
(51) Int. Cl.: H01L 21/02, H01L 21/68, H01L 21/203, H05B 3/68, H01L 21/31, H01L 21/027, H05B 3/74, H05B 3/02

(54) **HOLDER FOR SEMICONDUCTOR PRODUCTION SYSTEM**

(30) Priority: 13.03.2002 JP 2002067915; 29.05.2002 JP 2002154856
(71) Applicant: SUMITOMO ELECTRIC INDUSTRIES, Ltd, Osaka-shi, Osaka 541-0041 (JP)
(72) Inventor: KUIBIRA, Akira, c/o Sumitomo Electric Ind. Ltd., Itami-shi, Hyogo 664-0016 (JP); NATSUHARA, Masuhiro, c/o Sumitomo Elec. Ind. Ltd., Itami-shi, Hyogo 664-0016 (JP); NAKATA, Hirohiko, c/o Sumitomo Electric Ind. Ltd., Itami-shi, Hyogo 664-0016 (JP)
(74) Representative: Cross, Rupert Edward Blount
(86) International application number: PCT/JP2003/002670
(87) International publication number: WO 2003/077290

(57) **Abstract**

A holder for semiconductor manufacturing equipment is provided, in which electrical leakage and sparks do not occur across the electrode terminals and lead wires to supply power to a resistive heating element embedded in a holder, and the thermal uniformity in the holder is within ±1.0%.

The holder for semiconductor manufacturing equipment, that is provided in a chamber to which reactive gas is supplied, comprises a ceramic holder 1 which holds a treated material 10 on a surface thereof and is provided with a resistive heating element 2 for heating the material to be treated, and a support member 6 one end of which supports the ceramic holder 1 at a position other than the surface holding the material to be treated, and the other end of which is fixed to the chamber. Electrode terminals 3 and lead wires 4 of the resistive heating element 2 provided at a portion other than the surface of the ceramic holder 1 holding the material to be treated are housed within an insulating tube 5 in the holder 1 for the semiconductor manufacturing equipment.

## Description

### TECHNICAL FIELD

This invention relates to a holder for semiconductor manufacturing devices, and in particular relates to heating devices used for heat-hardening of resin films in coater-developers for photolithography, and for heat-calcination of low-dielectric constant insulating films such as low-k films.

### BACKGROUND ART

In semiconductor manufacturing, Al circuits and Cu circuits on a semiconductor wafer are formed by Al sputtering, Cu plating and similar methods. However, in recent years, as semiconductor element integration densities rise and devices decrease in size, wiring line widths and widths between lines have grown narrower each year.

Al circuit and Cu circuit wiring patterns are formed using photolithography techniques. For example, after uniformly coating an Al film with a resin, an exposure system called a stepper is employed to print a pattern in the resin film, and by heat-hardening the resin film and removing unnecessary portions, a removal-pattern resin film is formed on the Al film to be used for wiring. Then an etching system is used to etch the Al film along the removal-pattern portion, and on removing the resin film, patterned Al wiring is obtained.

When wiring lines are in close proximity, signals in the lines interact each other; hence there is a need to eliminate interaction between wiring lines by filling areas between wiring lines and between layers with low-dielectric constant insulating material. Conventionally, silicon oxide has been used as the insulating material for this purpose; more recently, materials known as low-k materials have been used in insulating films with still lower dielectric constants. Low-k insulating films are formed by dispersing the material in a dispersing medium in slurry form, which is used in spin-coating to form a uniform film; then photolithography techniques the same as those described above are employed in pattern formation, following by heat-calcining using a heater to harden the film.

Heat-hardening of resin film for photolithography and heat-calcining of low-dielectric constant insulating film such as low-k film is performed within a system called a coater-developer; as this heater, for example, a heater formed by enclosing SUS foil, which is a resistive heating element, between quartz glass plates is used; electrode terminals for the resistive heating element are provided on the rear surface of the heater, and lead wires are connected to supply electric power from an external power supply device.

On the other hand, in CVD equipment used to form various thin films, a ceramic heater, in which an Mo coil is embedded in AlN or Si₃N₄ with high thermal conductivity and good corrosion resistance, is used. When a heater in which a resistive heating element is embedded in ceramic material with such a high thermal conductivity is employed, the heat generated in the resistive heating element diffuses within the ceramic material, and uniform heating can be secured at the wafer holding surface. Further, by using ceramic material with good heat resistance, a heater with excellent thermal resistance is obtained.

The surface opposite the wafer holding surface of such a ceramic heater is bonded to one end of a cylindrical AlN support member; the other end of this AlN support member is fixed in place to the chamber and sealed with an O-ring, and by this means the heater is supported by the chamber via the support member. Electrode terminals and lead wires for the power supply are poor corrosion resistant and are housed on the inside of the cylindrical AlN support member, so as not to be exposed to corrosive gases used within the chamber.

As stated above, in a conventional holder for semiconductor manufacturing equipment, electrode terminals and lead wires remain exposed and are passed through the interior of the cylindrical support member to the outside. Consequently the lead wires may make contact each other within the support member to cause electrical leakage. When the atmosphere inside the cylindrical support member is an air atmosphere, sparking between the electrode terminals or lead wires is rare, meanwhile in a reduced-pressure atmosphere or in a vacuum state sparks between electrode terminals and lead wires occur frequently.

When electrical leakage or sparks occur, the manufacturing process is halted temporarily, and not only may the product being processed become defective, but the resistive heating element embedded in the ceramic heater may be degraded, cracks tend to appear in the portions at the electrode terminals or lead wires, then these may cause failures.
Consequently a structure is sought which prevents such occurrences of electrical leakage and sparking between electrode terminals and lead wires.

In order to reduce semiconductor manufacturing costs, larger Si wafers are being used, and in recent years there have been movements from wafer diameters of 8 inches to 12 inches. Hence there have been mounting demands for more uniform heating of the holder which holds the wafer, in the heater devices employed in coater-developers used with photolithography resins and low-k material calcining. The thermal uniformity required over the holding surface of a holder employed in such applications is within ±1.0%, and still better uniformity, to be within ±0.5% is demanded.

### DISCLOSURE OF THE INVENTION

In light of these circumstances of the prior art, an object of this invention is to provide a holder for semiconductor manufacturing equipment that attains no occurrence of electrical leakage or sparks at the electrode terminals or lead wires used to supply power to the resistive heating element embedded in the wafer holder, as well as a thermal uniformity at the surface of the holder holding the material to be treated of within ±1.0%, and more preferably within ±0.5%.

In order to achieve the above object, a holder for semiconductor manufacturing equipment provided by this invention is a holder for semiconductor manufacturing equipment, provided in a chamber to which reactive gas is supplied, comprising:
a ceramic holder which holds a material to be treated on a surface thereof and which is provided with a resistive heating element to heat the material to be treated; and
a support member one end of which supports the ceramic holder at a position other than the surface holding the material to be treated and the other end of which is fixed to the chamber; and
wherein an electrode terminal and a lead wire of the resistive heating element provided in a position other than the surface of the ceramic holder holding the material to be treated are housed in an insulating tube.

In the above-described holder for semiconductor manufacturing equipment of this invention, it is preferable that the weight of the above ceramic holder is supported only by the above support member, or is supported by the above support member and by the above insulating tube.

In one form of the above holder for semiconductor manufacturing equipment of this invention, it is preferable that one end of the above insulating tube is hermetically sealed with the ceramic holder; or that the other end of the above insulating tube is hermetically sealed with the chamber; or that the other end of the above insulating tube is hermetically sealed; or that the space between the above lead wires and chamber is hermetically sealed. Of these, when the space between the other end of the above insulating tube and the chamber is hermetically sealed, it is preferable that the space between a side wall of the insulating tube and the chamber is sealed with an O-ring, and in particular that the O-ring is compressed in the insulating tube axis direction, so that the O-ring is pressed against the side wall of the insulating tube and the chamber.

In another form of the above semiconductor manufacturing device holder of this invention, it is preferable that the above support member is cylindrical, and that the atmosphere in the interior space thereof is maintained the same as the atmosphere in the above chamber, or that the atmosphere in the interior space thereof is a reduced-pressure atmosphere at pressure less than 0.1 MPa (1 atmosphere) or is in a vacuum state.

This invention provides a heating device used in the above-described semiconductor manufacturing equipment employing a holder for semiconductor manufacturing, such as a heating device used for heat-hardening of resin film in photolithography coater-developers or used for heat-calcining of low-dielectric constant insulating film.

In this invention, as the holder used to hold on the surface and heat a wafer or other material to be treated, a ceramic holder, with a resistive heating element embedded in an insulating ceramic plate, is used. By housing electrode terminals and wires within a cylindrical insulating tube and thereby insulating them, the electrode terminals and wires of the resistive heating element, which are positioned on an area other than the surface of the ceramic holder for holding a material to be treated, can effectively prevent from electrical leakage due to contact and sparks between electrode terminals and lead wires.
Each unit comprising lead wires and electrode terminals may be housed separately in an insulating tube, or a single insulating tube having a plurality of through-holes may be used, in a structure enabling insertion of a unit into each through-hole.

The ceramic holder must be supported within the chamber, then it can be supported either by the separately provided support member alone, or by both the support member and the insulating tube. There is no need to support the ceramic holder only by the insulating tube; hence there is little stress applied to the cylindrical insulating tube, and so the insulating tube can be manufactured with the minimum inner diameter and wall thickness necessary to protect the electrode terminals and lead wires.

The cylindrical insulating tube is manufactured by sintering of ceramic material, and so increasing the inner diameter and wall thickness even slightly results in a large increase in manufacturing cost. Manufacturing costs can be reduced by using the smallest possible inner diameter and wall thickness for the insulating tube. By reducing the insulating tube wall thickness, the escape of heat via the insulating tube can be suppressed, so that temperature reduction of the ceramic holder in contact with the insulating tube is suppressed, and thermal uniformity can be improved.

Furthermore, supporting the ceramic holder by the separately provided support member alone, at the same time, separating one end of the insulating tube from the ceramic holder or slightly contacting them can prevent the heat generated by the resistive heating element from escaping through the insulating tube from the ceramic holder to the outside. Hence drops in temperature of the ceramic holder other than at the surface holding the material to be treated are suppressed, and thermal uniformity is further improved.

If the cylindrical insulating tube is not merely placed so as to cover the electrode terminals and lead wires, but the space between one end and the ceramic holder is also hermetically sealed, then the occurrence of sparks in the gap is also suppressed. When thus sealing the space between one end of the insulating tube and the ceramic holder, and particularly when completely bonding the two, it is preferable from the standpoint of thermal stress that the difference in thermal expansion coefficients of the two at room temperature is 5x10⁻⁶ /°C or less. It is still more preferable that the difference in thermal expansion coefficients is 2x10⁻⁶ /°C or less.

When the difference in the thermal expansion coefficients of the insulating tube and the ceramic holder is large, upon sealing and bonding the difference in contraction amounts after bonding may cause thermal stress, resulting in breakage of the insulating tube. In such cases, by slideably mating two insulating tubes with different diameters, contraction can be released and stress can be relaxed.

If the thermal conductivity of the insulating tube is high, heat generated by the ceramic holder escapes from the bonded portion to the insulating tube, the temperature is decreased locally, and the thermal uniformity of the ceramic holder as a whole is reduced. In such cases, by reducing the thermal conductivity of the insulating tube to below the thermal conductivity of the ceramic holder, the escape of heat from the ceramic holder via the insulating tube can be suppressed, and thermal uniformity of the ceramic holder as a whole can be improved.

When bonding the insulating tube and ceramic holder for the purpose of hermetic sealing, glass, an AlN bonding material, or a brazing metal or other is used. As glass, for example B-Si glass, or an oxide of a group IIa or group IIIa element or an oxide of Al is used. As AlN bonding material, for example, an oxide of a group IIa or group IIIa element is added to AlN, or an oxide of Al is added for use. At this time, AlN may be the principal component, but another component may also be used as the principal component. As brazing metal, for example an active metal bond employing for example Ti-Cu-Ag may be used, or after W metallization, Ni plating may be performed, followed by Ag-Cu brazing.

If the space between one end of the cylindrical insulating tube and the ceramic holder is hermetically sealed as described above, and the space between the other end of the insulating tube and the chamber or between the lead wires and the chamber is also hermetically sealed, the occurrence of sparks can be completely suppressed, which is still more desirable. By using an O-ring to seal the space between the side wall at the other end of the insulating tube and the chamber, and the space between the lead wires and the chamber, inexpensive and highly reliable hermetic sealing can be performed.

This O-ring seal between the side wall at the other end of the insulating tube and the chamber can be performed by inserting an O-ring on the inside of a hole opened in the chamber, inserting the insulating tube thereinto and sealing. However, because the dimensions of the insulating tube which can be inserted are constrained by the elastic properties and dimensions of the O-ring, the sealing performance of the O-ring are constrained. In order to independently control the O-ring seal performance, a specialized O-ring compression jig can be used to compress the O-ring in the insulating tube axis direction, so that the O-ring is pressed against the insulating tube wall and the chamber, and the sealing properties can be improved.

If the other end of the above insulating tube is hermetically sealed with a polyimide resin or other resin sealing material, a seal which is simple, inexpensive, and reliable can be formed.

In this invention, the electrode terminals and lead wires are protected by the cylindrical insulating tube, and so the support member need not necessarily be cylindrical. When using a cylindrical support member, it is preferable that the atmosphere on the inside substantially surrounded by the cylindrical support member is the same as the atmosphere on the outside portion (the atmosphere within the chamber). By this means, the escape of heat from other than the surface of the ceramic holder holding the material to be treated is the same for the inside portion effectively surrounded by the cylindrical support member, and for the outside portion, so that the temperature difference between the inner and outer peripheries is reduced, and thermal uniformity is improved.

In a conventional AlN holder for use in CVD systems, an AlN cylindrical support member is bonded to the holder and the electrode terminals and lead wires are protected thereby, and moreover the interior of the support member is maintained at a pressure of 0.1 MPa (one atmosphere). In this case, heat from the holder escapes via the cylindrical support member to the gas atmosphere at 0.1 MPa (one atmosphere) on the inside, so that the thermal uniformity of the holder is reduced. Hence when the support member in this invention is cylindrical, by maintaining the interior substantially surrounded by this cylindrical support member to a reduced atmosphere of less than 0.1 MPa (one atmosphere) or in a vacuum state, the escape of heat through the gas to the inside of the cylindrical support member can be reduced, and so the thermal uniformity of the ceramic holder is improved.

As the material of the ceramic holder, it is preferable, from the standpoints of corrosion resistance, heat resistance, insulation and other properties, that aluminum nitride (AlN), silicon carbide (SiC), aluminum oxide (Al₂O₃), or silicon nitride (Si₃N₄) is used. As the material of the cylindrical insulating tube also, from the standpoints of corrosion resistance, heat resistance, insulation and other properties, it is preferable that AlN, SiC, Al₂O₃, Si₃N₄, or mullite (3Al₂O₃•2SiO₂) be used.

It is preferable that the thermal conductivity of the support member supporting the ceramic holder is low, in order that the escape of heat generated by the ceramic holder can be suppressed; in particular, a thermal conductivity of 30 W/mK or lower is preferable. As the material of the support member, from the standpoints of corrosion resistance, heat resistance, insulation, and low thermal conductivity, stainless steel, titanium, aluminum oxide, mullite, spinel, cordierite, or similar is preferable.

As the resistive heating element, there are no particular restrictions so long as embedding in the ceramic holder is possible and the material has heat resistance and an appropriate resistivity; for example, W, Mo, Ag, Pd, Pt, Ni, Cr, stainless steel, or similar can be used.

The holder for semiconductor manufacturing equipment of this invention is particularly suitable as a heating device used in resin film heat-hardening in a photolithography coater-developer and in heat-calcining of low-dielectric constant insulating film.

### BRIEF DESCRIPTION OF THE DRAWINGS

Fig. 1 is a summary cross-sectional view showing an embodiment of the holder for semiconductor manufacturing equipment of this invention.

Fig. 2 is a summary cross-sectional view showing another embodiment of the holder for semiconductor manufacturing equipment of this invention.

Fig. 3 is a summary cross-sectional view showing another embodiment of the holder for semiconductor manufacturing equipment of this invention.

Fig. 4 is a summary cross-sectional view showing still another embodiment of the holder for semiconductor manufacturing equipment of this invention.

Fig. 5 is a summary cross-sectional view showing still another embodiment of the holder for semiconductor manufacturing equipment of this invention.

Fig. 6 is a summary cross-sectional view showing an embodiment of an O-ring seal provided between an insulating tube and chamber in the holder for semiconductor manufacturing equipment of this invention.

Fig. 7 is a summary cross-sectional view showing another embodiment of an O-ring seal provided between an insulating tube and chamber in the holder for semiconductor manufacturing equipment of this invention.

### BEST MODE FOR CARRYING OUT THE INVENTION

Below, this invention is explained in specific terms, based on examples and a comparative example.

### Example 1

0.5 weight percent yttria (Y₂O₃) was added as a sintering agent to aluminum nitride (AlN) powder, and after further adding an organic binder, dispersing and mixing, spray-drying was used for granulation. The granulated powder was molded using a uniaxial press, to obtain, after sintering, two disc-shaped molded bodies of diameter 350 mm and thickness 5 mm. Also, a sintering agent with the same composition was added to the same AlN powder, and after further adding an organic binder for use in extrusion, a dispersing agent and solvent, followed by kneading, the kneaded material was then extrusion-molded to obtain, after sintering, two molded bodies in tube shapes, with external diameter 10 mm, inner diameter 8 mm, and of length 100 mm.

These two disc-shaped molded bodies and two tube-shaped molded bodies were degreased in a nitrogen flow at a temperature of 900°C, and were then further sintered for five hours at a temperature of 1900°C in a nitrogen flow. The AlN sintered bodies thus obtained all had a thermal conductivity of 180 W/mK. The entire surfaces of these sintered bodies were polished using diamond abrasives.

A slurry formed by adding a sintering agent and ethyl cellulose binder to W powder and kneading was used to print a resistive heating element circuit on one surface of one of the disc-shaped AlN sintered bodies, and after degreasing at 900°C in a nitrogen flow, firing was performed for one hour at 1850°C. A slurry formed by adding an ethyl cellulose binder to a bonding glass and kneading was applied to one surface of the other disc-shaped sintered body, and degreased at 900°C in a nitrogen flow.

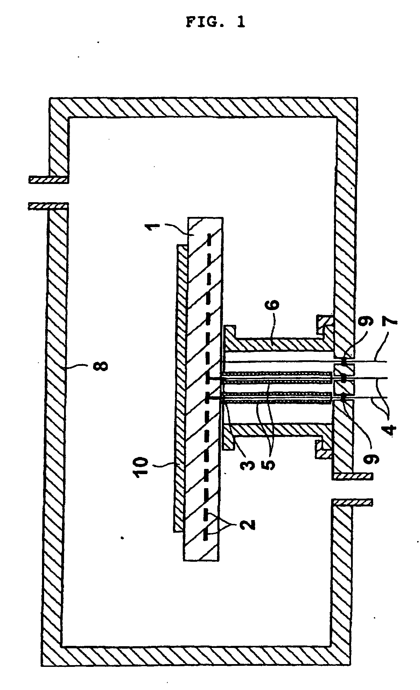

These two sintered bodies were stacked, with the bonding glass surface facing the resistive heating element surface, and with a 5 kPa (50 g/cm²) load applied to prevent slippage, bonding was performed by heating for two hours at 1800°C, to fabricate a ceramic holder 1 in the interior of which was embedded a resistive heating element 2, as shown in Fig. 1.

Tungsten electrode terminals 3 to be connected to the resistive heating element 2 were bonded to the rear surface of the ceramic holder 1, and lead wires 4, which were electrically connected to an external power supply for the supply of power, were further bonded to the surface. The above two tube-shaped AlN sintered bodies, constituting insulating tubes 5, were made to house inside the electrode terminals 3 and lead wires 4, after which B-Si glass for bonding was applied to one end face thereof, which was brought into contact with the rear surface of the ceramic holder 1, and with a 5 kPa (50 g/cm²) load applied to prevent slippage, bonding was performed by heating for one hour at 800°C.

Further, a substantially cylindrical support member 6, consisting of SUS pipe with thermal conductivity 15 W/mK, with outer diameter of 100 mm, inner diameter of 90 mm and length 100 mm, and provided with flanges on both ends, was fabricated. A flange on the other end of this substantially cylindrical support member 6 was clamped to the chamber 7, and the ceramic holder 1 was placed, without bonding, on the flange on one end thereof.

The two insulating tubes 5 bonded to the rear surface of the ceramic holder 1 were housed within the cylindrical support member 6, and each of the other ends of the insulating tubes 5 were set in a position 0.5 mm above the bottom surface of the chamber 8. The spaces between the lead wires 4 and thermocouple lead wires 7 and the bottom surface of the chamber 8 were all hermetically sealed with O-rings 9.

A reduced-pressure nitrogen atmosphere of pressure 13.3 Pa (0.1 torr) was maintained within the chamber 8 of this equipment, and power at a voltage of 200 V was applied to the resistive heating element 2 from the external power supply to heat the ceramic heater 1 to 500°C. At this time, no sparking between the electrode terminals 3 and lead wires 4 or other problems occurred even when the power supply was turned on and off 500 times. Moreover, ten ceramic holders 1 were each subjected to rising-temperature and falling-temperature cycle 500 times, without any problems occurring in any of the ten holders. Also, upon measuring the full-surface thermal uniformity of the surface of the ceramic holder 1 holding the material to be treated on which a wafer 10 was placed, a thermal uniformity of 500°C ±0.43% was obtained.

### Example 2

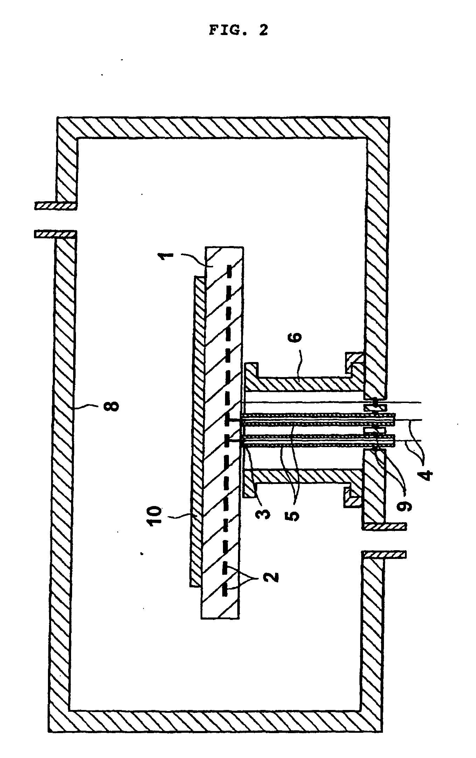

As shown in Fig. 2, except for extending the other ends of the AlN insulating tubes 5 to pass through the bottom of the chamber 8, and using O-rings 9 to hermetically seal the spaces between the surfaces on the other ends of the insulating tubes 5 and the bottom of the chamber 8, the device was configured the same as Example 1. Evaluations of the equipment configured in this way were performed the same as those of Example 1.

The ceramic holder was heated to 500°C under the same conditions as in the Example 1, and no sparking between the electrode terminals 3 and lead wires 4 or other problems occurred even when the power supply was turned on and off 500 times. Moreover, no problems occurred in any of ten ceramic holders 1 subjected to 500 cycles of rising-temperature and falling-temperature processes. The thermal uniformity of the ceramic holder was 500°C ±0.46%.

### Example 3

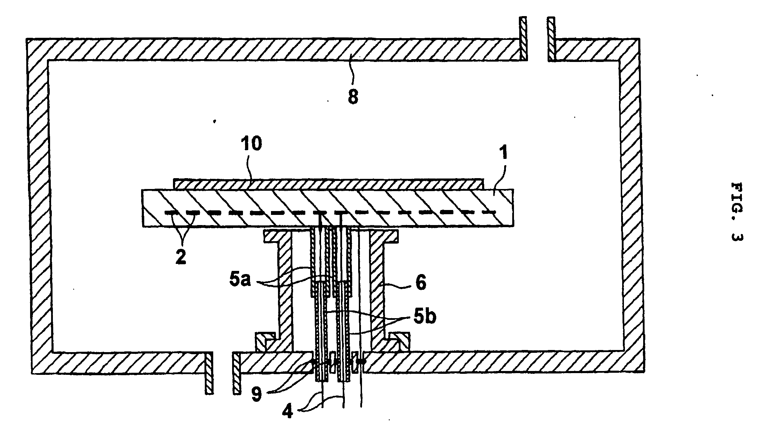

As shown in Fig. 3, except for mating the two AlN insulating tubes 5a, 5b having different diameters for use as the insulating tubes, the device was configured the same as Example 2. The insulating tubes 5a had an outer diameter of 12 mm, inner diameter of 10.5 mm, and length of 60 mm. The insulating tubes 5b had an outer diameter of 10 mm, an inner diameter of 8 mm, and a length of 60 mm.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders 1 even when rising-temperature and falling-temperature processes were repeated 500 times. The thermal uniformity of the ceramic holder was 500°C ±0.46%.

### Example 4

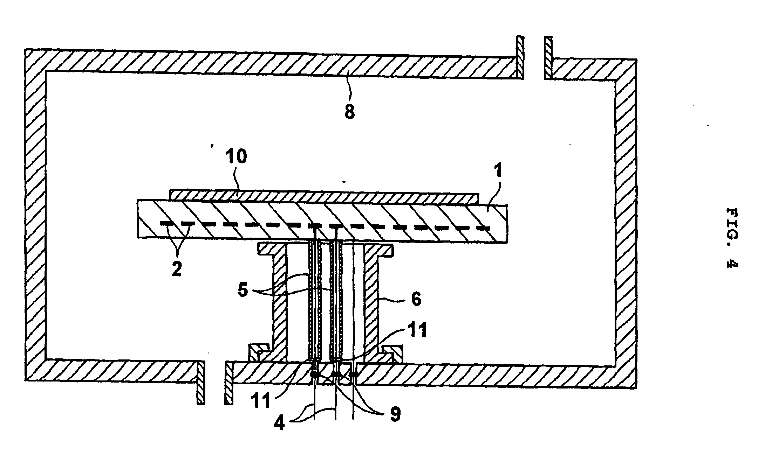

As shown in Fig. 4, except for making the AlN insulating tubes 5 with an outer diameter of 10 mm, inner diameter of 8 mm, and of length 90 mm, and hermetically sealing the openings at the other ends of the insulating tubes 5 with a polyimide resin sealing material 11 with the lead wires 4 passing through, the equipment was configured the same as to that in Example 1.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.45%.

### Example 5

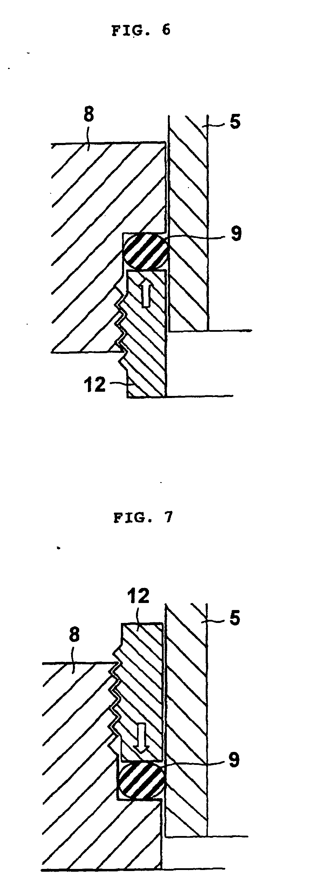

The equipment was configured as shown in Fig. 2, the same as the case of Example 2. However, as shown in Fig. 6, in this device holes with larger diameters below and smaller diameters above were opened in the chamber 8, O-rings 9 were placed on the insides of the holes, and the insulating tubes 5 were inserted; in addition, by inserting from below cylindrical crimping jigs 12 which screwed into a threaded portion provided on a side wall of the large-diameter hole and screwing in place, the O-rings 9 were crimped in the axial direction of the insulating tubes 5, pressing against the side walls of the insulating tubes 5 and the chamber 8 to form a seal.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.45%.

### Example 6

The equipment was configured as shown in Fig. 2, the same as the case of Example 2. However, as shown in Fig. 7, in this device holes with larger diameters above and smaller diameters below were opened in the chamber 8, O-rings 9 were placed on the insides of the holes, and the insulating tubes 5 were inserted; in addition, by inserting from above cylindrical crimping jigs 12 which screwed into a threaded portion provided on a side wall of the large-diameter hole and screwing in place, the O-rings 9 were crimped in the axial direction of the insulating tubes 5, pressing against the side walls of the insulating tubes 5 and the chamber 8 to form a seal.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.45%.

### Example 7

The same method as in Example 1 was used to fabricate a ceramic holder from AlN. On the other hand, the insulating tubes were fabricated by adding 0.5 weight percent yttria (Y₂O₃) and 5 weight percent alumina (Al₂O₃), as sintering agents, to aluminum nitride powder, dispersing and mixing, then adding a binder for extrusion, dispersing agent, plasticizer, and solvent, and after kneading, performing molding the same way as Example 1, followed by degreasing and sintering. Bonding of the AlN insulating tubes and sealing of the lead wires were performed the same as Example 1. The thermal conductivity of the AlN sintered bodies used in the ceramic holder was 180 W/mK, and the thermal conductivity of the insulating tubes was 70 W/mK.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.39%.

### Example 8

The same method as in Example 1 was used to fabricate a ceramic holder from AlN. On the other hand, the insulating tubes were fabricated by adding, as sintering agents, 20 weight percent Al₂O₃ and 3 weight percent Y₂O₃ to mullite (3Al₂O₃.2SiO₂); except for these sintering agents, the same materials were added as in Example 1, and kneading and extrusion molding were performed. After degreasing in an air flow at a temperature of 700°C, the molded bodies were sintered for three hours at 1500°C in a nitrogen flow. The thermal conductivity of the mullite sintered bodies thus obtained was 4 W/mK. The entire surfaces of these sintered bodies were polished using diamond abrasives, and the parts were used as insulating tubes.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. Upon measuring the thermal uniformity of the ceramic holder, the temperature drop at the bonding portion between holder and insulating tubes seen in Example 1 did not appear, and the thermal uniformity was improved to 500°C ±0.35%.

### Example 9

Two weight percent boron carbide (B₄C) was added as a sintering agent to silicon carbide (SiC) powder; after further adding a PVB (polyvinyl butyral) binder, dispersing agent, plasticizer and solvent, and after kneading, the kneaded material this obtained was extrusion-molded to obtain, after sintering, two tube-shaped molded bodies of outer diameter 10 mm, inner diameter 8 mm, and length 100 mm. These molded bodies were degreased in argon at 800°C, then sintered for six hours at 2000°C in argon. The thermal conductivity of the SiC insulating tubes thus obtained was 150 W/mK.

B-Si glass was applied to one end of these SiC insulating tubes, and these were brought into contact with the rear surface of an AlN ceramic holder fabricated under the same conditions as in Example 1; with electrode terminals and lead wires housed within, bonding was performed by heating to 800°C for one hour. Otherwise, the device configuration was the same as that of Example 1.
The difference in thermal expansion coefficients of the AlN ceramic holder and SiC insulating tubes was 1.5x10⁻⁶ /°C.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Also, the thermal uniformity of the ceramic holder was 500°C ±0.42%. However, upon repeating rising- and falling-temperature processes 500 times, a crack appeared at the portion bonded with an insulating tube in one among ten ceramic holders.

### Example 10

Two weight percent magnesia (MgO) was added as a sintering agent to aluminum oxide (Al₂O₃) powder; after further adding a PVB (polyvinyl butyral) binder, dispersing agent, plasticizer and solvent, and after kneading, the kneaded material this obtained was extrusion-molded to obtain, after sintering, two tube-shaped molded bodies of outer diameter 10 mm, inner diameter 8 mm, and length 100 mm. These molded bodies were sintered for three hours at 1500°C in air. The thermal conductivity of the Al₂O₃ insulating tubes thus obtained was 20 W/mK.

B-Si glass was applied to one end of these Al₂O₃ insulating tubes, and these were brought into contact with the rear surface of an AlN ceramic holder fabricated under the same conditions as in Example 1; with electrode terminals and lead wires housed within, bonding was performed by heating to 800°C for one hour. Otherwise, the device configuration was the same as that of Example 1.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Also, the thermal uniformity of the ceramic holder was 500°C ±0.40%. However, because the difference in thermal expansion coefficients of the AlN ceramic holder and the Al₂O₃ insulating tubes was 2.2x10⁻⁶ /°C, upon repeating rising- and falling-temperature processes 500 times, cracks appeared at the portion bonded with an insulating tube in nine out of ten ceramic holders.

### Example 11

Two weight percent yttria (Y₂O₃) and 1 weight percent alumina (Al₂O₃) were added as sintering agents to silicon nitride (Si₃N₄) powder; after further adding a PVB (polyvinyl butyral) binder, dispersing agent, plasticizer and solvent, and after kneading, the kneaded material this obtained was extrusion-molded to obtain, after sintering, two tube-shaped molded bodies of outer diameter 10 mm, inner diameter 8 mm, and length 100 mm. These molded bodies were degreased at 900°C in a nitrogen flow, and then sintered for five hours at 1650°C in air. The thermal conductivity of the Si₃N₄ insulating tubes thus obtained was 30 W/mK.

B-Si glass was applied to one end of these Si₃N₄ insulating tubes, and these were brought into contact with the rear surface of an AlN ceramic holder fabricated under the same conditions as in Example 1; with electrode terminals and lead wires housed within, bonding was performed by heating to 800°C for one hour. Otherwise, the device configuration was the same as that of Example 1. The difference in the thermal expansion coefficients of the AlN ceramic holder and the Si₃N₄ insulating tubes was 1.3x10⁻⁶ /°C.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.39%.

### Example 12

The same method as in Example 1 was used to fabricate a ceramic holder and insulating tubes from AlN and a SUS support member; however, one end of the AlN insulating tubes was bonded to the rear surface of the ceramic holder the same as Example 1, the other end was brought into contact with the chamber, to support a portion (50%) of the weight of the ceramic holder. Otherwise, the device configuration was the same as that in Example 1.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders 1 even when rising-temperature and falling-temperature processes were repeated 500 times. The thermal uniformity of the ceramic holder was 500°C ±0.70%.

### Example 13

Except for adding Y₂O₃ to AlN powder, further adding an ethyl cellulose binder and kneading into a paste which was applied when bonding the AlN ceramic holder to the insulating tubes, then bonding in nitrogen at 1800°C; the device configuration was the same as that in Example 1.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.50%.

### Example 14

Except for using 100 µm foil of an active silver brazing (Ti-Cu-Ag) when bonding the AlN ceramic holder to the insulating tubes, to bond in high vacuum (1.3x10⁻³ Pa (10⁻⁵ torr)) at 850°C, the device configuration was the same as that in Example 1.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.45%.

### Example 15

Except for forming a W metallization layer on both the bonded ends when bonding the AlN ceramic holder to the insulating tubes, and after further plating Ni to a thickness of 2 µm, using 100 µm foil of a silver brazing (Cu-Ag) to bond in vacuum (1.3 Pa (10⁻² torr)) at 850°C, the device configuration was the same as that in Example 1.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.46%.

### Example 16

Except for fabricating cylindrical support members using titanium, aluminum oxide (alumina), mullite, spinel, and cordierite, the device configuration was the same as that in Example 1.
The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times.

Table 1 shows the results of measurements of the thermal uniformity of ceramic holders, together with the thermal conductivities of the support members.

**Table 1**

| Support member material | Thermal conductivity (W/mK) | Thermal uniformity (%) |
|---|---|---|
| Titanium | 17 | ±0.48 |
| Alumina | 20 | ±0.49 |
| Mullite | 4 | ±0.47 |
| Spinel | 17 | ±0.47 |
| Cordierite | 1.3 | ±0.47 |

### Example 17

The same AlN granulated powder as in Example 1 was used to fabricate a cylindrical support member with outer diameter 80 mm, inner diameter 75 mm, and of length 100 mm. This AlN support member was used in place of the SUB support member in Example 1; one end was bonded to the center of the rear surface of the AlN ceramic holder, the same as the case of the AlN insulating tubes in Example 1. Except for filling the interior of this cylindrical support member with nitrogen gas at 0.1 MPa (one atmosphere), the device was configured the same as to Example 2 to obtain the equipment shown in Fig. 2.

The equipment configured in this way was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±1.50%.

### Example 18

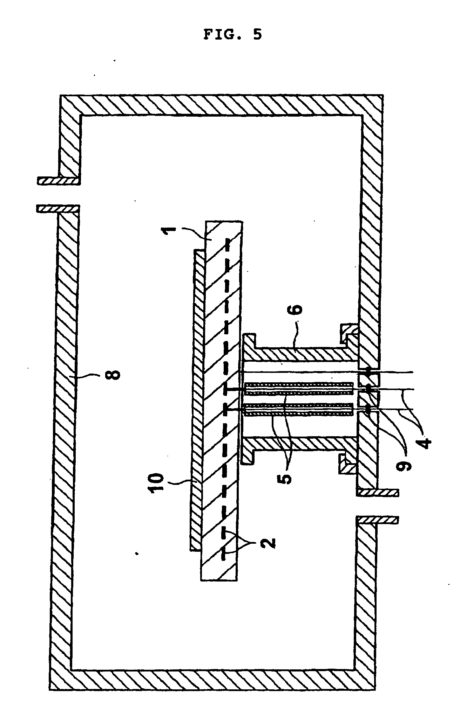

Two AlN insulating tubes with outer diameter 10 mm, inner diameter 8 mm and length 90 mm, inside of which were housed and set the electrode terminals and lead wires, were fabricated using the method of Example 1. The equipment configuration was the same as that in Example 1 without sealing both ends of the insulating tubes as shown in Fig. 5.

The equipment configured in this way was evaluated under the same conditions as in Example 1. That is, the ceramic holder was heated to 500°C, and upon turning the power supply on and off 500 times, a minute discharge occurred only once across the gap between an insulating tube and the ceramic holder, but that did not cause a trouble such as burning of the connection portions between the resistive heating element and electrode terminals or other problems. Moreover, no problems occurred in any of ten ceramic holders even when rising-temperature and falling-temperature processes were repeated 500 times. The thermal uniformity of the ceramic holder was 500°C ±0.40%.

### Example 19

Two weight percent boron carbide (B₄C) was added as a sintering agent to silicon carbide (SiC) powder, and after adding an organic binder, dispersing and mixing, granulation by spray-drying was performed. The granulated powder was subjected to molding in a uniaxial press, to obtain, after sintering, two disc-shaped molded bodies of diameter 350 mm and thickness 5 mm.

Also, 2 weight percent boron carbide was added as a sintering agent to the same silicon carbide, and after further adding a binder for extrusion, dispersing agent, plasticizer and solvent, followed by kneading, the kneaded material was extrusion-molded to obtain two tube-shaped molded bodies which, after sintering, had an outer diameter of 10 mm, inner diameter of 8 mm, and length 100 mm.

These molded bodies were degreased in argon at 800°C, then sintered for six hours at 2000°C in argon. The thermal conductivity of the SiC sintered bodies thus obtained was 150 W/mK. The disc-shaped sintered bodies were used, in the same way as Example 1, to form a W circuit followed by bonding, to fabricate an SiC ceramic holder. The tube-shaped sintered bodies were used as insulating tubes, inside of which the electrode terminals and lead wires were housed, with the lead wires drawn outside.

The equipment, which otherwise was configured the same as Example 1, was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.44%.

### Example 20

Two weight percent magnesia (MgO) was added as a sintering agent to aluminum oxide (Al₂O₃) powder, and after adding an organic binder, dispersing and mixing, granulation by spray-drying was performed. The granulated powder was subjected to molding in a uniaxial press, to obtain, after sintering, two disc-shaped molded bodies of diameter 350 mm and thickness 5 mm. Also, 2 weight percent magnesia was added as a sintering agent to the same aluminum oxide powder, and after further adding a PVB (polyvinyl butyral) binder, dispersing agent, plasticizer and solvent, followed by kneading, the kneaded material was extrusion-molded to obtain two tube-shaped molded bodies which, after sintering, had an outer diameter of 10 mm, inner diameter of 8 mm, and length 100 mm.

These molded bodies were sintered for three hours at 1500°C in air. The thermal conductivity of the Al₂O₃ sintered bodies thus obtained was 20 W/mK. The disc-shaped sintered bodies were used, the same way as Example 1, to form a W circuit followed by bonding, to fabricate an Al₂O₃ ceramic holder. The tube-shaped sintered bodies were used as insulating tubes, inside of which the electrode terminals and lead wires were housed, with the lead wires drawn outside.

The equipment, which otherwise was configured the same as Example 1, was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.60%.

### Example 21

Two weight percent yttria (Y₂O₃) and 1 weight percent alumina (Al₂O₃) were added as sintering agents to silicon nitride (Si₃N₄) powder, and after adding an organic binder, dispersing and mixing, granulation by spray-drying was performed. The granulated powder was subjected to molding in a uniaxial press, to obtain, after sintering, two disc-shaped molded bodies of diameter 350 mm and thickness 5 mm.

Also, 2 weight percent yttria and 1 weight percent alumina were added as sintering agents to the same silicon nitride powder, and after further adding a PVB (polyvinyl butyral) binder, dispersing agent, plasticizer and solvent, followed by kneading, the kneaded material was extrusion-molded to obtain two tube-shaped molded bodies which, after sintering, had an outer diameter of 10 mm, inner diameter of 8 mm, and length 100 mm.

These molded bodies were sintered for five hours at 1650°C in nitrogen. The thermal conductivity of the Si₃N₄ sintered bodies thus obtained was 30 W/mK. The disc-shaped sintered bodies were used, the same way as Example 1, to form a W circuit followed by bonding, to fabricate an Si₃N₄ ceramic holder. The tube-shaped sintered bodies were used as insulating tubes, inside of which the electrode terminals and lead wires were housed, with the lead wires drawn outside.

The equipment, which otherwise was configured the same as Example 1, was evaluated under the same conditions as in Example 1. That is, the ceramic holder was heated to 500°C, and upon turning the power supply on and off 500 times, no sparking between the electrode terminals and lead wires or other problems occurred. Moreover, no problems occurred in any of ten ceramic holders even when rising-temperature and falling-temperature processes were repeated 500 times. The thermal uniformity of the ceramic holder was 500°C ±0.80%.

### Comparative Example

The same method as in Example 1 was used to fabricate a ceramic holder of AlN, and except for not protecting the lead wires with insulating tubes, the equipment was configured the same as Example 1.

The ceramic holder was heated to 500°C under the same conditions as in Example 1. Upon turning the power supply on and off five times, large-current sparks appeared across the electrode terminals, and the embedded resistive heating element was burned.

### INDUSTRIAL APPLICABILITY

By means of this invention, a holder for semiconductor manufacturing equipment can be provided such that there is no occurrence of electrical leaks or sparks between electrode terminals and lead wires used to supply power to a resistive heating element embedded in a ceramic holder, and moreover the thermal uniformity of the surface of the ceramic holder for holding a material to be treated is within ±1.0%, and possibly within ±0.5%. This holder for semiconductor manufacturing equipment is extremely advantageous for heat-hardening of resin films for photolithography and in the heating devices of coater-developers used in heat-calcining of low-dielectric constant insulating films in particular.

## Claims

1. A holder for semiconductor manufacturing equipment, provided in a chamber to which reactive gas is supplied, comprising:
a ceramic holder which holds a material to be treated on a surface thereof and which is provided with a resistive heating element to heat the material to be treated; and
a support member one end of which supports the ceramic holder at a position other than the surface holding the material to be treated and the other end of which is fixed to the chamber; and
wherein an electrode terminal and a lead wire of the resistive heating element provided in a position other than the surface of the ceramic holder holding the material to be treated are housed in an insulating tube.

2. A holder for semiconductor manufacturing equipment according to Claim 1, wherein a weight of said ceramic holder is supported only by said support member, or is supported by said support member and by said insulating tube.

3. A holder for semiconductor manufacturing equipment according to Claim 1 or 2, wherein a hermetic seal is formed between one end of said insulating tube and the ceramic holder.

4. A holder for semiconductor manufacturing equipment according to Claim 3, wherein the hermetic seal between the one end of said insulating tube and the ceramic holder is formed from glass, an aluminum nitride bonding material, or metal brazing.

5. A holder for semiconductor manufacturing equipment according to any of Claims 1 through 4, wherein a hermetic seal is formed between the other end of said insulating tube and the chamber.

6. A holder for semiconductor manufacturing equipment according to Claim 5, wherein, at the other end of said insulating tube, an O-ring seal is provided between the chamber and a side wall of the insulating tube.

7. A holder for semiconductor manufacturing equipment according to Claim 6, wherein, by crimping said O-ring in an axial direction of the insulating tube, the O-ring is pressed against the side wall of insulating tube and the chamber.

8. A holder for semiconductor manufacturing equipment according to any of Claims 1 through 5, wherein the other end of said insulating tube is hermetically sealed.

9. A holder for semiconductor manufacturing equipment according to any of Claims 1 through 8, wherein a thermal conductivity of said insulating tube is lower than a thermal conductivity of the ceramic holder.

10. A holder for semiconductor manufacturing equipment according to any of Claims 1 through 9, wherein a space between said lead wire and the chamber is hermetically sealed.

11. A holder for semiconductor manufacturing equipment according to any of Claims 1 through 10, wherein the difference in thermal expansion coefficients at room temperature of said ceramic holder and of said insulating tube is 5.4x10⁻⁶ /°C or lower.

12. A holder for semiconductor manufacturing equipment according to any of Claims 1 through 11, wherein said support member is cylindrical, and an atmosphere in an interior space thereof is maintained the same as an atmosphere in the chamber.

13. A holder for semiconductor manufacturing equipment according to any of Claims 1 through 12, wherein said support member is cylindrical, and an atmosphere in an interior space thereof is a reduced-pressure atmosphere of pressure less than 0.1 MPa (one atmosphere) or is in vacuum.

14. A holder for semiconductor manufacturing equipment according to any of Claims 1 through 13, wherein said ceramic holder is formed from at least one ceramic material selected from among aluminum nitride, silicon carbide, aluminum oxide and silicon nitride.

15. A holder for semiconductor manufacturing equipment according to any of Claims 1 through 14, wherein said insulating tube is formed from at least one ceramic material selected from among aluminum nitride, silicon carbide, aluminum oxide, silicon nitride and mullite.

16. A holder for semiconductor manufacturing equipment according to any of Claims 1 through 15, wherein said support member is formed from metal or ceramic material having a thermal conductivity of 30 W/mK or less.

17. A holder for semiconductor manufacturing equipment according to Claim 16, wherein said support member is formed from at least one selected from among stainless steel, titanium, aluminum oxide, mullite, spinel and cordierite.

18. A semiconductor manufacturing equipment which uses the holder for semiconductor manufacturing equipment according to any of Claims 1 through 17.

19. A semiconductor manufacturing equipment according to Claim 18, wherein the semiconductor manufacturing equipment which uses said holder for semiconductor manufacturing equipment is a heating device used for heat-hardening of resin film for coater-developers in photolithography or for heat-calcining of low-dielectric constant insulating film.
